# EUROPEAN PATENT APPLICATION

(11) **EP 2 562 810 A1**
(43) Date of publication of application: **27.02.2013**
(21) Application number: 12179611.4
(22) Date of filing: 08.08.2012
(51) Int. Cl.: H01L 23/495, H01L 23/49

(54) **Small-outline package for a power transistor**

(30) Priority: 22.08.2011 US 201161525948 P; 25.07.2012 US 201213557716
(71) Applicant: International Rectifier Corporation, El Segundo, CA 90245 (US)
(72) Inventor: Munoz, Jorge, Cypress, CA 90630 (US)
(74) Representative: Dr. Weitzel & Partner

(57) **Abstract**

According to an exemplary embodiment, a small-outline package includes a power transistor having a source and a drain, the power transistor situated on a paddle of a leadframe of the small-outline package. The source of the power transistor is electrically connected to a plurality of source leads. The drain of the power transistor is electrically and thermally connected to a top side of the paddle of the leadframe, the paddle of the leadframe being exposed from a bottom surface of the small-outline package, thereby providing a direct electrical contact to the drain from a bottom side of the paddle of the leadframe.

## Description

### BACKGROUND OF THE INVENTION

The present application claims the benefit of and priority to a pending provisional application entitled "Small-Outline Package for a Power Transistor," Serial No. 61/525,948 filed on August 22, 2011. The disclosure in this pending provisional application is hereby incorporated fully by reference into the present application.

### 1. FIELD OF THE INVENTION

The present invention is generally in the field of semiconductors. More particularly, the invention relates to the packaging of semiconductor devices.

### 2. BACKGROUND ART

Quad flat no-lead (QFN) packages have become popular for housing power transistors, such as power metal-oxide-semiconductor field-effect transistor (MOSFETs). These power QFN (PQFN) packages offer good current carrying capability and thermal performance, which are of great concern when housing a power transistor. However, because PQFN packages are leadless, testing of PQFN packages can be challenging and require expensive pogo pin contactors or other costly testing equipment. Furthermore, PQFN packages are half-molded and therefore are fragile and lack robustness. Thus, PQFN packages have not been readily adopted in many industrial applications, such as automotive applications, due to concerns over maintaining the integrity of the packaging.

Small-outline integrated circuit (SOIC) packages offer an alternative to QFN packages and can often be used as a drop-in replacement. For example, an eight-lead SOIC, or SO8, package can be used as a drop-in replacement for a QFN 5x6 package. SO8 packages can easily be tested due to having a leaded design. Furthermore, SO8 packages are overmolded, thereby providing a durable and robust package. Thus, SO8 packages are more suitable for industrial applications than QFN 5x6 packages. Additionally, SO8 packages are typically approximately 30% to 40% less expensive than QFN 5x6 packages. However, conventional SO8 packages house integrated circuits and not power devices, such as power transistors. One reason conventional SO8 packages do not house power transistors is due to poor current carrying capability and thermal performance. For example, a typical SO8 package has poor thermal resistance rated from junction to ambient at 60 degrees Celsius per Watt.

It would be desirable to provide leaded small-outline packages, such as SO8 packages, having current carrying capability and thermal performance suitable for power transistors.

### SUMMARY OF THE INVENTION

A small-outline package for a power transistor, substantially as shown in and/or described in connection with at least one of the figures, and as set forth more completely in the claims.

### BRIEF DESCRIPTION OF THE DRAWINGS

Figure 1A shows a top view of an exemplary small-outline package, according to one embodiment of the present invention.
Figure 1B shows a bottom view of an exemplary small-outline package, according to one embodiment of the present invention.
Figure 1C shows a side view of an exemplary small-outline package, according to one embodiment of the present invention.
Figure 2 shows a top view of an exemplary small-outline package, according to one embodiment of the present invention.

### DETAILED DESCRIPTION OF THE INVENTION

The present invention is directed to small-outline packages with at least one power transistor. The following description contains specific information pertaining to the implementation of the present invention. One skilled in the art will recognize that the present invention may be implemented in a manner different from that specifically discussed in the present application. Moreover, some of the specific details of the invention are not discussed in order to not obscure the invention. The specific details not described in the present application are within the knowledge of a person of ordinary skill in the art.

The drawings in the present application and their accompanying detailed description are directed to merely exemplary embodiments of the invention. To maintain brevity, other embodiments of the invention that use the principles of the present invention are not specifically described in the present application and are not specifically illustrated by the present drawings.

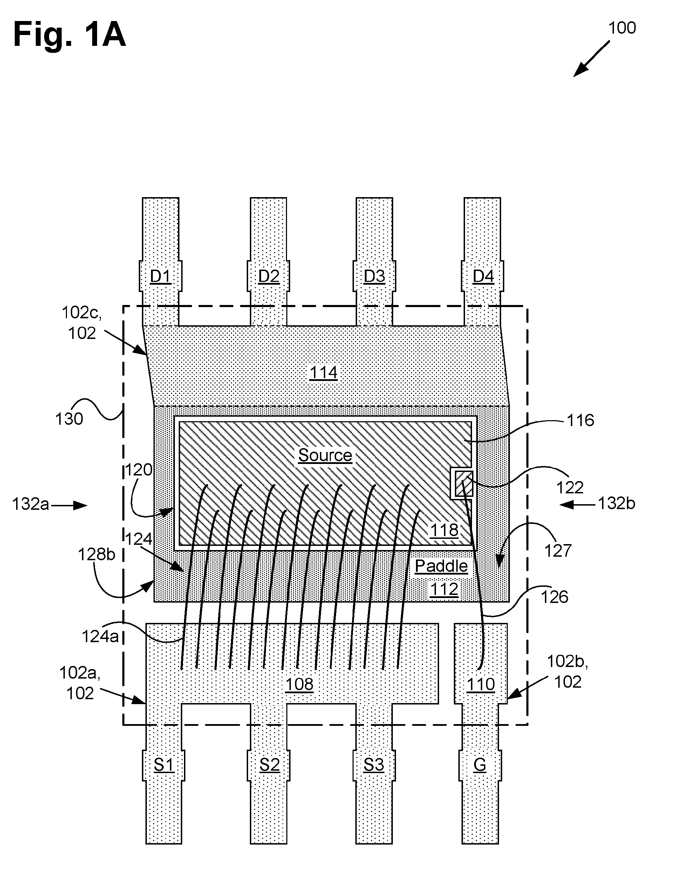

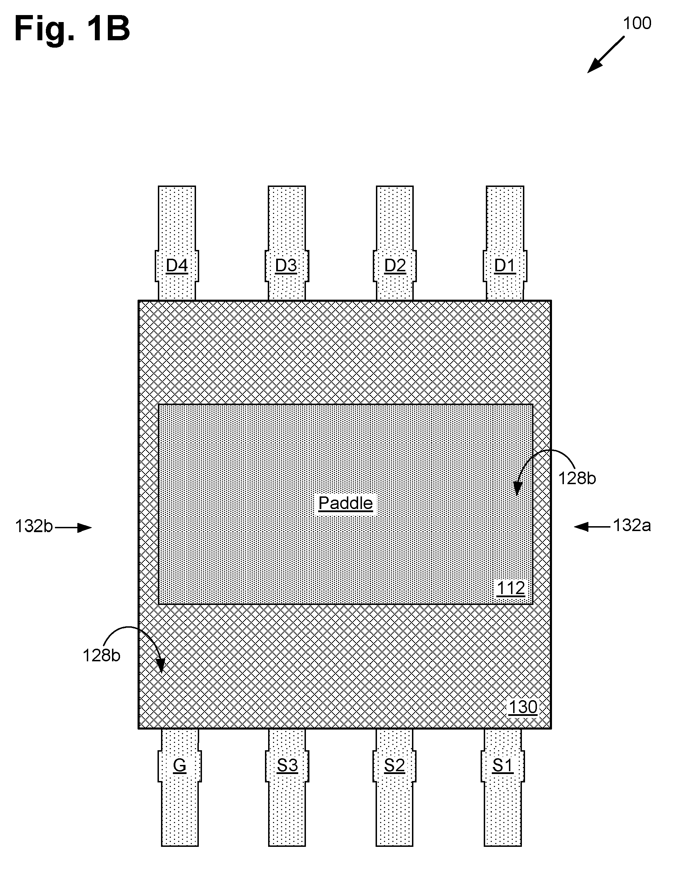

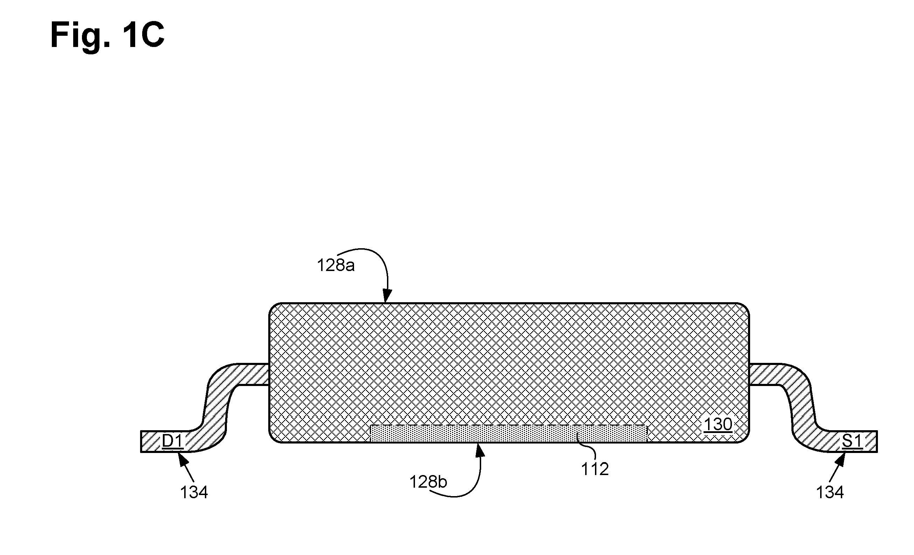

Figures 1A, 1B, and 1C show different views of small-outline package 100, according to one embodiment of the present invention. More particularly, Figure 1A shows a top view of small-outline package 100, Figure 1B shows a bottom view of small-outline package 100, and Figure 1C shows a side view of small-outline package 100. In the present embodiment, small-outline package 100 is a small-outline integrated circuit (SOIC) package, and more particularly, is an SO8, or eight-leaded small-outline package. While the present embodiment is an eight-leaded small-outline package, in other embodiments small-outline package 100 has more or fewer leads.

Figure 1A shows that small-outline package 100 includes leadframe 102 comprising source side leadframe 102a, gate side leadframe 102b, and drain side leadframe 102c, which can be singulated from a composite leadframe (not shown in Figure 1A). Source side leadframe 102a includes source leads S1, S2, and S3 and source pad 108. Gate side leadframe 102b includes gate lead G and gate pad 110. Drain side leadframe 102c includes paddle 112, bent drain pad 114, and drain leads D1, D2, D3, and D4.

In the present embodiment, small-outline package 100 is overmolded, thereby providing for a durable and robust package. Figure 1A depicts a dashed outline of molding 130, which can be a plastic molding. Molding 130 is shown in Figures 1B and 1C and covers the region within the dashed outline in Figure 1A. In small-outline package 100, drain leads D1, D2, D3, and D4, source leads S1, S2, S3, gate lead G, and paddle 112 protrude from molding 130.

Small-outline package 100 comprises power transistor 116 having source 118, drain 120, and gate 122. In the present embodiment, power transistor 116 is a field-effect transistor (FET), such as a power metal-oxide-semiconductor field-effect transistor (MOSFET), but can generally be any power transistor according to various embodiments of the present invention. As a specific example, in the present embodiment, power transistor 116 is a HEX-1.4, 20-40 V, N-channel GEN 10.59 MOSFET from International Rectifier Corporation. Manifestly, this is merely one example, and numerous other power transistors can be used that are not discussed in the present application to preserve brevity. Power transistor 116 has dimensions of approximately 50 mils by 145 mils by 8 mils. Thus, from left to right in Figure 1A, power transistor 116 has a length of 145 mils. It will be appreciated that power transistor 116 can have different dimensions from those specified herein. Figure 1A shows that source 118 and gate 122 are on a top surface of power transistor 116 and that drain 120 is on a bottom surface of power transistor 116, which is opposite to the top surface.

Source 118 of power transistor 116 is electrically coupled to plurality of source leads S1, S2, and S3. More particularly, source 118 of power transistor 116 is electrically coupled to three source leads S1, S2, and S3 through plurality of bond wires 124. Plurality of bond wires 124 can comprise, for example, copper and/or aluminum bond wires. In one embodiment plurality of bond wires 124 are 2 mil copper wires. Figure 1A illustrates fourteen bond wires, including bond wire 124a, however, it will be appreciated that small-outline package 100 can include more or fewer bondwires. In the present embodiment, plurality of bond wires 124 are electrically and mechanically connected to source 118 and source pad 108. Source pad 108 offers a large post area to accommodate many plurality of bond wires 124. As source leads S1, S2, and S3 are electrically and mechanically coupled to and integrated with source pad 108, source side leadframe 102a has high current carrying capability. Furthermore, source leadframe 102a can act as a path for heat dissipation through source leads S1, S2, and S3, thereby lowering thermal resistance of small-outline package 100.

In the present embodiment, there are three of source leads S1, S2, and S3, which can be connected to an external circuit. It will be appreciated that other embodiments may include more or fewer source leads (and small-outline package 100 can include more or fewer leads in general that may serve as source, drain, and gate leads). For example, any combination of the leads shown in Figure 1A can be gate leads, drain leads, or source leads by modifying leadframe 102 and/or the orientation of components within small-outline package 100. In one embodiment, there are four source leads. For example, gate lead G may instead be a source lead and gate pad 110 may instead be a part of source pad 108 (and not be coupled to bond wire 126). Also, in some embodiments, gate lead G may be adjacent drain leads, such as drain lead D3, instead of source leads, as shown in the Figure 1A. For example, three drain leads (e.g., D1, D2, and D3) may be adjacent a gate lead and those four leads may be on a side of small-outline package 100 opposite to a side having four source leads.

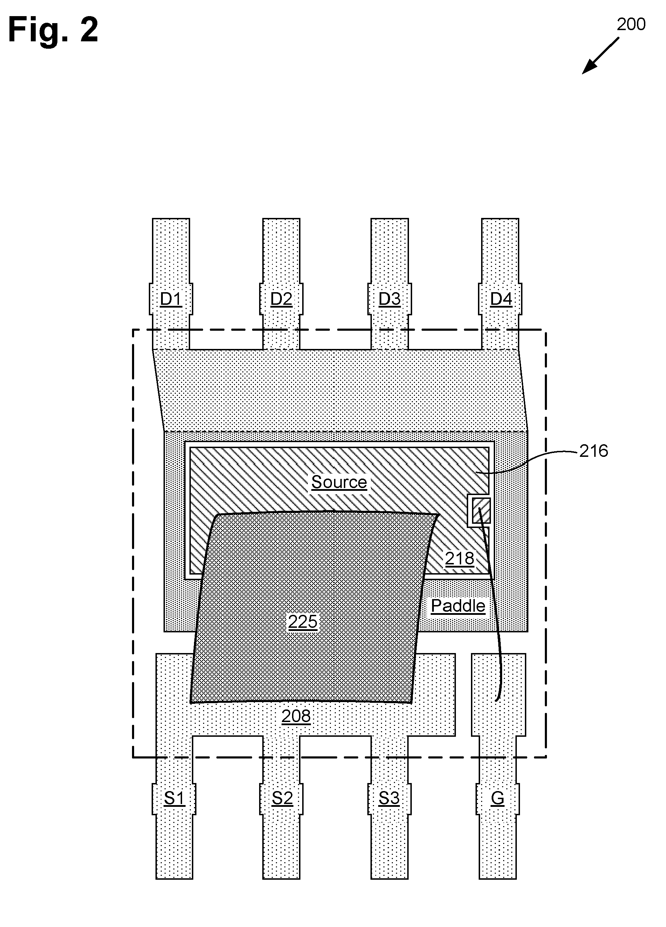

While, in the embodiment shown in Figure 1A, source 118 of power transistor 116 is electrically coupled to source leads S1, S2, and S3 through plurality of bond wires 124, other means can be utilized to electrically couple source 118 of power transistor 116 to source leads S1, S2, and S3. For example, Figure 2 shows small-outline package 200, corresponding to small-outline package 100 in Figures 1A, 1B, and 1C. Small-outline package 200 includes source pad 208, power transistor 216, source 218, and source leads S1, S2, and S3 corresponding respectively to source pad 108, power transistor 116, source 118, and source leads S1, S2, and S3 in small-outline package 100. In one embodiment, small-outline package 200 can be similar to or the same as small-outline package 100 except that source 218 of power transistor 216 is electrically coupled to source leads S1, S2, and S3 through power strip 225 as opposed to plurality of bond wires 124. In some embodiments, power strip 225 is a conductive clip, such as a copper clip. In embodiments where power strip 225 is a conductive clip, source 218 of power transistor 216 may comprise a solderable front metal (SFM) and power strip 225 may be soldered to source 218 and source pad 208. In other embodiments, power strip 225 is a conductive ribbon, such as an aluminum ribbon, and can, for example, be mechanically attached to source 218 and source pad 208 utilizing ultrasonic vibrations for bonding. Power strip 225 is electrically and mechanically connected to source 218 and source pad 208. Utilizing power strip 225 can further enhance current carrying capability of small-outline package 200 as compared to plurality of bond wires 124.

Returning to Figure 1A, Figure 1A shows gate 122 of power transistor 116 is electrically coupled to gate lead G. More particularly, gate 122 of power transistor 116 is electrically coupled to gate lead G through bond wire 126. In the present embodiment, bond wire 126 is electrically and mechanically connected to gate 122 and gate pad 110. Also in the present embodiment, as gate 122 has lower current requirements than source 118, gate 122 is electrically coupled to less leads than source 118 (e.g., only one gate lead G). However, in other embodiments, gate 122 is electrically coupled to more than one gate lead and can also be electrically coupled to more bond wires than what is shown in Figure 1A.

Power transistor 116 is situated on paddle 112 of drain side leadframe 102c of small-outline package 100. In the present embodiment, from left to right, paddle 112 has a length of approximately 3.9 millimeters (153.5 mils) and has a width of approximately 1.9 (74.8 mils) millimeters, although other dimensions are possible. In small-outline package 100, drain 120 of power transistor 116 is electrically and thermally connected to top side 127 of paddle 112 of drain side leadframe 102c. Drain 120 of power transistor 116 can be electrically and thermally connected to top side 127 of paddle 112 of drain side leadframe 102c utilizing, for example, solder, solder paste, or other conductive material.

Paddle 112 of drain side leadframe 102c is electrically coupled to plurality drain leads D1, D2, D3, and D4. More particularly, drain side leadframe 102c comprises four drain leads D1, D2, D3, and D4 and bent drain pad 114 to electrically couple paddle 112 of drain side leadframe 102c to drain leads D1, D2, D3, and D4. Drain leads D1, D2, D3, and D4 are electrically and mechanically coupled to and integrated with bent drain pad 114. Furthermore, drain leads D1, D2, D3, and D4 are electrically and mechanically coupled to and integrated with paddle 112 of leadframe 102c. As such, drain side leadframe 102c has high current carrying capability. Furthermore, drain leadframe 102c can act as a path for heat dissipation through drain leads D1, D2, D3, and D4 thereby lowering thermal resistance of small-outline package 100. In the present embodiment, there are four of drain leads D1, D2, D3, and D4, which can be connected to an external circuit.

In the present embodiment, paddle 112 of drain side leadframe 102c is recessed relative to source pad 108 of source side leadframe 102a. Bent drain pad 114 is sloped downward to recess leadframe 102c relative to source pad 108. As such, paddle 112 of drain side leadframe 102c can be exposed from bottom surface 128b of small-outline package 100, thereby providing a direct electrical contact to drain 120 from bottom side 128b of paddle 112 of drain side leadframe 102c.

Figure 1B shows a bottom view of small-outline package 100, with paddle 112 being exposed from bottom surface 128b of small-outline package 100. In the present embodiment, a bottom side of paddle 112 (shown in Figure 1B) and molding 130 are flush on bottom surface 128b of small-outline package 100. As drain 120 of power transistor 116 is in good thermal and electrical contact with paddle 112, thermal resistance of small-outline package 100 can be significantly improved. Additionally, because paddle 112 is electrically connected to drain 120 of power transistor 116, paddle 112 can be electrically connected to an external circuit, thereby further enhancing current carrying capability of small-outline package 100.

Although in the present embodiment, drain side leadframe 102c is exposed from bottom surface 128b of small-outline package 100, in other embodiments, drain side leadframe 102c can be exposed from other surfaces of small-outline package 100 in addition to or instead of bottom surface 128b. For example, in one embodiment, drain side leadframe 102c is exposed from top surface 128a (shown in Figure 1C) of small-outline package 100 instead of or in addition to bottom surface 128b. In such an embodiment, power transistor 116 may be on a bottom side of paddle 112 instead of top side 127. Furthermore, bent drain pad 114 may sloped upward as opposed to downward.

Referring to Figure 1C, Figure 1C shows a side view of small-outline package 100. The side view shown is Figure 1C is facing side 132a in Figures 1A and 1B. Thus, Figure 1C shows source lead S1 and drain lead D1. However, in the present embodiment, if the side view shown in Figure 1C were to face side 132b in Figures 1A and 1B, Figure 1C could be said to show gate lead G and drain lead D4 by only modifying labeling. It is noted that in the present embodiment, paddle 112 is not visible within molding 130 from side 132a, but is indicated in Figure 1C with a dashed outline to designate its presence within molding 130. In the present embodiment, drain leads D1, D2, D3, and D4, source leads S1, S2, and S3, and gate lead G have substantially coplanar end portions 134, which can be mounted on and/or electrically connected to a substrate (not shown in Figure 1C). Furthermore, bottom surface 128b of small-outline package 100 can be mounted on and/or electrically connected to the substrate.

Conventional SO8 packages house an integrated circuit (IC) and not a power device, such power transistor 116. One reason conventional SO8 packages do not house power transistors is due to poor thermal performance. For example, a conventional SO8 package has thermal resistance rated from junction to ambient at 60 degrees Celsius per Watt. However, small-outline package 100 can have low thermal resistance rated from junction to case, that can be, for example approximately 4 degrees Celsius per Watt. In addition to having poor thermal resistance, another reason conventional SO8 packages do not house power transistors is due to having low current carrying capability. However, small-outline package 100 can have sufficient current carrying capability to support power devices, such as power transistor 116.

From the above description of the invention it is manifest that various techniques can be used for implementing the concepts of the present invention without departing from its scope. Moreover, while the invention has been described with specific reference to certain embodiments, a person of ordinary skill in the art would appreciate that changes can be made in form and detail without departing from the spirit and the scope of the invention. Thus, the described embodiments are to be considered in all respects as illustrative and not restrictive. It should also be understood that the invention is not limited to the particular embodiments described herein but is capable of many rearrangements, modifications, and substitutions without departing from the scope of the invention.

## Claims

1. A small-outline package comprising:
a power transistor having a source and a drain, said power transistor situated on a paddle of a leadframe of said small-outline package;
said source of said power transistor electrically connected to a plurality of source leads;
said drain of said power transistor electrically and thermally connected to a top side of said paddle of said leadframe, said paddle of said leadframe being exposed from a bottom surface of said small-outline package, thereby providing a direct electrical contact to said drain from a bottom side of said paddle of said leadframe.

2. The small-outline package of claim 1, wherein said paddle of said leadframe is electrically coupled to a plurality of drain leads.

3. The small-outline package of claim 1, wherein said leadframe further comprises a plurality of drain leads and a bent drain pad to electrically couple said paddle of said leadframe to said plurality of drain leads.

4. The small-outline package of claim 1, wherein said paddle of said leadframe is recessed relative to a source pad of said leadframe.

5. The small-outline package of claim 1, wherein said source of said power transistor is electrically coupled to said plurality of source leads through a plurality of bond wires.

6. The small-outline package of claim 1, wherein said source of said power transistor is electrically coupled to said plurality of source leads through a conductive ribbon.

7. The small-outline package of claim 1, wherein said plurality of source leads are electrically and mechanically coupled to and integrated with a source pad.

8. The small-outline package of claim 1, comprising a plurality of drain leads electrically and mechanically coupled to and integrated with a drain pad.

9. The small-outline package of claim 1, comprising a plurality of drain leads electrically and mechanically coupled to and integrated with said paddle of said leadframe.

10. The small-outline package of claim 1, wherein there are three of said plurality of source leads.

11. The small-outline package of claim 1, wherein a gate of said power transistor is electrically coupled to a gate lead.

12. An eight-lead small-outline package comprising:
a power transistor having a source and a drain, said power transistor situated on a paddle of a leadframe of said eight-lead small-outline package;
said source of said power transistor electrically connected to three source leads;
said drain of said power transistor electrically and thermally connected to a top side of said paddle of said leadframe, said paddle of said leadframe being exposed from a bottom surface of said eight-lead small-outline package, thereby providing a direct electrical contact to said drain from a bottom side of said paddle of said leadframe.

13. The eight-lead small-outline package of claim 12, wherein said paddle of said leadframe is electrically coupled to four drain leads.

14. The eight-lead small-outline package of claim 12, wherein said leadframe further comprises four drain leads and a bent drain pad to electrically couple said paddle of said leadframe to said four drain leads.

15. The eight-lead small-outline package of claim 12, wherein said paddle of said leadframe is recessed relative to a source pad of said leadframe.
